# DEMANDE DE BREVET EUROPEEN

(11) **EP 3 633 487 A1**
(43) Date de publication de la demande: **08.04.2020**
(21) Numéro de dépôt: 19200897.7
(22) Date de dépôt: 01.10.2019
(51) Int. Cl.: G05F 1/46, H02M 3/16, H03F 1/34, H03F 3/217

(54) **CONVERTISSEUR À DÉCOUPAGE**

(30) Priorité: 05.10.2018 FR 1859261
(71) Demandeur: STMicroelectronics (Grenoble 2) SAS, 38000 Grenoble (FR)
(72) Inventeur: CHESNEAU, David, 38000 GRENOBLE (FR); ESCH, Helene, 38170 SEYSSINET PARISET (FR); AMIARD, François, 38120 PROVEYSIEUX (FR)
(74) Mandataire: Cabinet Beaumont

(57) **Abrégé**

La présente description concerne un dispositif comprenant : un amplificateur opérationnel (10) ; et une boucle de contre réaction (11) connectée entre une première entrée (103) de l'amplificateur et une sortie (101) de l'amplificateur, la boucle de contre réaction étant commandable en fonction de la saturation de l'amplificateur.

## Description

### Domaine technique

La présente description concerne de façon générale les circuits électroniques. Elle concerne plus particulièrement les convertisseurs d'énergie DC/DC, de type alimentation à découpage, qui convertissent une tension continue en une autre tension continue.

### Technique antérieure

Dans un convertisseur à découpage, une tension d'alimentation, fournie à une entrée du convertisseur, est découpée (ou hachée) en commutant un ou plusieurs interrupteurs de découpage de manière à mettre en oeuvre des phases d'accumulation d'énergie dans un élément inductif et des phases de restitution, à une charge connectée en sortie du convertisseur, de l'énergie accumulée dans cet élément inductif.

Les convertisseurs à découpage connus présentent divers inconvénients.

### Résumé de l'invention

Un mode de réalisation prévoit un convertisseur à découpage qui pallie tout ou partie des inconvénients des convertisseurs à découpage usuels.

Un mode de réalisation pallie plus particulièrement tout ou partie des inconvénients liés à la saturation d'un amplificateur d'erreur d'un dispositif tel qu'un convertisseur à découpage.

Un mode de réalisation prévoit un dispositif comprenant : un amplificateur opérationnel ; et une boucle de contre réaction connectée entre une première entrée de l'amplificateur et une sortie de l'amplificateur, la boucle de contre réaction étant commandable en fonction de la saturation de l'amplificateur et comprenant un interrupteur connecté entre la première entrée et la sortie de l'amplificateur, ou une résistance variable commandable connectée entre la première entrée et la sortie de l'amplificateur.

Selon un mode de réalisation, le dispositif comprend en outre un circuit de détection d'une saturation de l'amplificateur, configuré pour commander la boucle de contre réaction.

Selon un mode de réalisation, le circuit de détection est configuré pour réduire ou annuler l'impédance de la boucle de contre réaction lorsque l'amplificateur sature.

Selon un mode de réalisation, le circuit est configuré pour détecter une saturation de l'amplificateur et pour commander la boucle de contre réaction à partir d'un signal interne de l'amplificateur.

Selon un mode de réalisation, l'amplificateur comprend un premier transistor dont une borne de conduction constitue la sortie de l'amplificateur, ledit signal interne étant reçu par une borne de commande du premier transistor.

Selon un mode de réalisation, le circuit est configuré pour commander une fermeture de l'interrupteur lorsqu'une saturation est détectée ou pour commander une diminution de la valeur de la résistance variable quand une saturation est détectée.

Selon un mode de réalisation, le circuit est une connexion directe entre la borne de commande du premier transistor et une borne de commande de l'interrupteur.

Selon un mode de réalisation, le circuit comprend une première résistance et un deuxième transistor connectés en série entre des bornes d'alimentation de l'amplificateur, une borne de commande du deuxième transistor étant connectée à la borne de commande du premier transistor, et un noeud de connexion entre la première résistance et le deuxième transistor étant connecté à une borne de commande de la résistance variable.

Selon un mode de réalisation, l'interrupteur ou la résistance variable correspondent à un troisième transistor dont une première borne de conduction est connectée à la première entrée de l'amplificateur, et dont une deuxième borne de conduction est connectée à la sortie de l'amplificateur.

Selon un mode de réalisation, la saturation est une saturation à potentiel d'alimentation haut, en valeur absolue, de l'amplificateur.

Selon un mode de réalisation, la première entrée est une entrée inverseuse de l'amplificateur.

Selon un mode de réalisation, le dispositif comprend en outre : un élément inductif dont une première borne est couplée, de préférence connectée, à une borne de sortie du dispositif ; un circuit de commutation couplé à une deuxième borne de l'élément inductif ; et un circuit de commande, de préférence en modulation de largeur d'impulsion, configuré pour commander le circuit de commutation au moins en partie sur la base d'un signal de sortie de l'amplificateur.

Selon un mode de réalisation, le dispositif est un convertisseur de tension à découpage, de préférence un convertisseur abaisseur, abaisseur-élévateur ou inverseur.

Un autre mode de réalisation prévoit un microcontrôleur comprenant un convertisseur de tension à découpage tel que défini précédemment.

Un autre mode de réalisation prévoit un procédé de commande d'un dispositif comprenant un amplificateur opérationnel et une boucle de contre réaction commandable connectée entre une sortie de l'amplificateur et une première entrée, de préférence inverseuse, de l'amplificateur, le procédé comprenant une étape consistant à réduire ou annuler l'impédance de la boucle de contre réaction lorsqu'une saturation de l'amplificateur est détectée.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique, un mode de réalisation d'un convertisseur à découpage, par exemple de type abaisseur ;
la figure 2 représente, de manière plus détaillée, une partie du convertisseur de la figure 1 selon un mode de réalisation ;
la figure 3 représente, de manière plus détaillée, une partie du convertisseur de la figure 1 selon un autre mode de réalisation ; et
la figure 4 représente des résultats de simulations.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et/ou matérielles identiques.

Par souci de clarté, seuls les étapes et éléments utiles à la compréhension des modes de réalisation décrits ont été représentés et sont détaillés. En particulier, les divers circuits de commutation comprenant un ou plusieurs interrupteurs de découpage d'un convertisseur à découpage, et les circuits et/ou les procédés de commande de ces interrupteurs de découpage, notamment en modulation de largeur d'impulsion (PWM - Pulse Width Modulation) n'ont pas été détaillés, les modes de réalisation décrits étant compatibles avec les convertisseurs à découpage usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

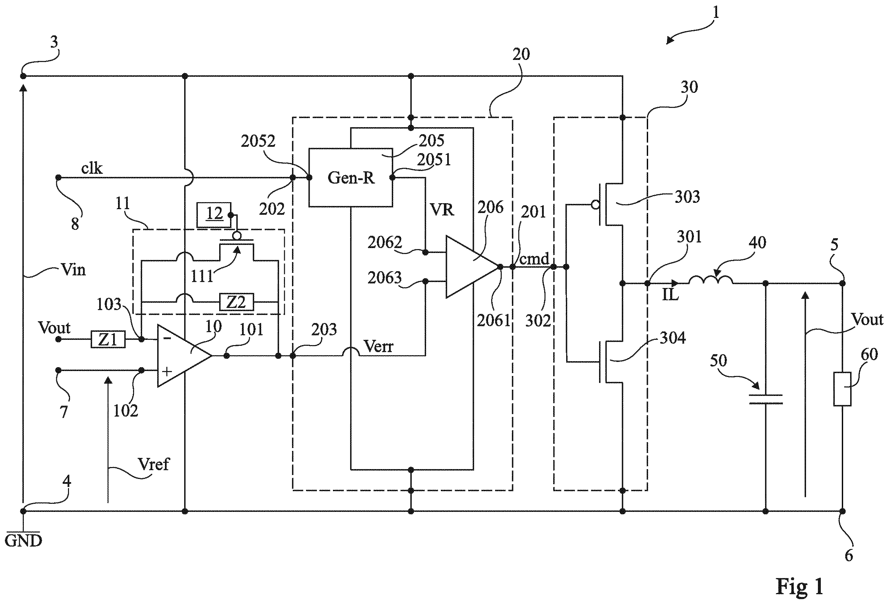

La figure 1 représente, de manière schématique, un mode de réalisation d'un convertisseur à découpage, et plus particulièrement d'un convertisseur à découpage DC/DC, c'est-à-dire un convertisseur à découpage qui convertit une tension continue d'alimentation en une autre tension continue. Dans cet exemple, le convertisseur est de type abaisseur, c'est-à-dire que la tension continue Vout qu'il fournit à une charge a une valeur inférieure, en valeur absolue, à la tension continue d'alimentation Vin qu'il reçoit.

Le convertisseur 1 comprend deux bornes ou noeuds 3 et 4 destinés à recevoir la tension continue d'alimentation Vin, et deux bornes ou noeuds de sortie 5 et 6 destinés à fournir la tension continue de sortie Vout. La tension Vin est par exemple positive et référencée au noeud 4, typiquement la masse GND. La tension Vout est par exemple positive et référencée au noeud 6, les noeuds 4 et 6 étant ici confondus. Dans cet exemple, le convertisseur 1 comprend en outre une borne d'entrée 7, les bornes d'entrée 7 et 4 étant destinées à recevoir une tension continue de consigne Vref, par exemple positive et référencée à la borne 4. Dans cet exemple, le convertisseur 1 comprend également une borne d'entrée 8 destinée à recevoir un signal binaire périodique, ou signal d'horloge, clk.

Le convertisseur 1 comprend un amplificateur opérationnel 10. L'amplificateur 10 a deux bornes d'alimentation connectées aux bornes respectives 3 et 4, de manière à être alimenté par la tension Vin. L'amplificateur 10 est un amplificateur d'erreur. Autrement dit, l'amplificateur 10 est configuré pour fournir, au niveau de sa borne de sortie 101, un signal de sortie Verr représentatif d'un écart entre la tension Vout et la tension de consigne Vref. Le signal Verr est par exemple la tension disponible entre les bornes 101 et 4, par exemple référencée à la masse 4. L'amplificateur 10 reçoit sur une borne d'entrée 102, de préférence son entrée non inverseuse (+), la tension de consigne Vref. Autrement dit, la borne 102 de l'amplificateur est couplée, de préférence connectée, à la borne 7. L'amplificateur 10 reçoit sur une deuxième borne d'entrée 103, de préférence son entrée inverseuse (-), la tension Vout ou une tension représentative de la tension Vout. Dans cet exemple, la borne 103 de l'amplificateur 10 est couplée à la borne 5 du convertisseur 1 par une impédance complexe Z1, c'est-à-dire un ou plusieurs composants résistifs et capacitifs dont l'impédance équivalente est l'impédance Z1. De préférence, l'impédance Z1 est connectée aux bornes respectives 5 et 103, ou, autrement dit, il n'y a que l'impédance Z1 entre les bornes 5 et 103.

Une boucle de contre réaction 11, de préférence de contre réaction négative, couple la borne de sortie 101 de l'amplificateur 10 à sa borne d'entrée 103. Dans ce mode de réalisation, on prévoit que la boucle de contre réaction 11 soit commandable en fonction de la saturation de l'amplificateur 10. Plus particulièrement, on prévoit de réduire, voire annuler, l'impédance de la boucle de contre réaction 11 lorsqu'une saturation de l'amplificateur 10 est détectée. Autrement dit, on tend à court-circuiter, voire on court-circuite, la sortie 101 de l'amplificateur 10 et l'entrée 103 de l'amplificateur 10 lorsque l'amplificateur 10 sature. De préférence, lorsque l'amplificateur 10 n'est plus saturé, la boucle de contre réaction 11 est commandée pour que son impédance retrouve sa valeur nominale, c'est-à-dire sa valeur en l'absence de saturation de l'amplificateur. De préférence, la valeur nominale de l'impédance de la boucle de contre réaction 11 est choisie de manière à assurer la stabilité de l'amplificateur, et plus précisément de la boucle comprenant l'amplificateur.

Dans cet exemple, la boucle de contre réaction 11 comprend une impédance complexe Z2, c'est-à-dire un ou plusieurs composants résistifs et capacitifs dont l'impédance équivalente est l'impédance Z2, connectée entre les bornes respectives 101 et 103. La boucle de contre réaction 11 comprend en outre un composant commandable 111, connecté entre les bornes respectives 101 et 103, dans cet exemple en parallèle de l'impédance Z2, correspondant à un interrupteur ou à une résistance variable commandable. Dans cet exemple, le composant 111 est un transistor, de préférence un transistor MOS, de préférence à canal P, dont les bornes de conduction (source/drain) sont couplées, de préférence connectées, aux bornes respectives 101 et 103.

Bien que la boucle de contre réaction 11 corresponde, dans cet exemple, à la connexion en parallèle d'une impédance complexe Z2 et d'un composant commandable 111, en variante, la boucle de contre réaction peut ne comprendre qu'une impédance complexe commandable connectée entre les bornes 101 et 103. Dans cette variante, l'impédance complexe est commandable de manière à réduire, voire annuler, l'impédance de la boucle de contre réaction 11 entre les bornes 101 et 103 lorsque l'amplificateur 10 sature.

Dans ce mode de réalisation, le convertisseur 1 comprend un circuit de commande 12 de la boucle de contre réaction 11, c'est-à-dire, dans cet exemple, du composant commandable 111. Plus particulièrement, le circuit 12 est configuré pour détecter une saturation de l'amplificateur 10, et pour commander la boucle de contre réaction 11 en conséquence. A titre d'exemple, le circuit 12 détecte la saturation de l'amplificateur 10 et commande la boucle de contre réaction 11 au moyen d'un signal interne de l'amplificateur, la connexion du circuit 12 à l'amplificateur pour obtenir ce signal interne n'étant pas représentée en figure 1. En outre, bien que cela ne soit pas représenté dans l'exemple de la figure 1, le circuit 12 peut être connecté entre les bornes 3 et 4 pour être alimenté par la tension Vin.

Le convertisseur 1 comprend également un circuit de commande de commutation, ou circuit de commande de découpage, 20, par exemple connecté entre les bornes 3 et 4 pour être alimenté par la tension Vin. Le circuit 20 est configuré pour déterminer au moins un signal de commande de découpage, ou signal de commande de commutation, au moins en partie sur la base du signal Verr de sortie de l'amplificateur 10. Le ou les signaux de commande de découpage sont de préférence des signaux modulés en largeur d'impulsion, par exemple des signaux dont le rapport cyclique dépend de la valeur de la tension Verr. Le ou les signaux de commande de découpage sont par exemple également déterminés à partir du signal clk.

Dans l'exemple représenté, le circuit 20 fournit un unique signal de commande de découpage cmd, au niveau de sa borne de sortie 201. En outre, le circuit 20 comprend une borne d'entrée 202 couplée, de préférence connectée, à la borne 8 pour recevoir le signal clk, et une borne d'entrée 203 couplée, de préférence connectée, à la borne de sortie 101 de l'amplificateur 10 pour recevoir la tension Verr.

Dans cet exemple, le circuit 20 comprend plus particulièrement un générateur de rampe 205 (Gen-R) et un comparateur 206, le générateur 205 et/ou le comparateur 206 étant par exemple connectés entre les bornes 3 et 4 pour être alimentés par la tension Vin.

Le générateur 205 est configuré pour fournir un signal de rampe VR au niveau de sa borne de sortie 2051. De préférence, le signal VR est périodique avec la même période que le signal clk, une borne d'entrée 2052 du générateur 205 recevant le signal clk de l'entrée 202. Le signal VR est par exemple une tension disponible entre les bornes 2051 et 4, et référencée à la borne de masse 4. A titre d'exemple la valeur de la tension VR est nulle au début de chaque période du signal clk, et croît jusqu'à une valeur maximale, de préférence la valeur de la tension d'alimentation Vin, atteinte à la fin de chaque période du signal clk.

Le comparateur 206 est ici configuré pour fournir, au niveau de sa borne de sortie 2061 couplée, de préférence connectée à la borne 201, le signal cmd. Le comparateur 206 détermine le signal cmd à partir des signaux, ou tensions, VR et Verr qu'il reçoit sur ses bornes d'entrées respectives 2062 et 2063, la borne 2062 étant couplée, de préférence connectée, à la borne 2051, et la borne 2061 étant couplée, de préférence connectée, à la borne 203.

Le convertisseur 1 comprend en outre un circuit de commutation 30 (en trait pointillé en figure 1). Le circuit 30 est connecté entre les bornes 3 et 4 pour recevoir la tension d'alimentation Vin. Le circuit 30 comprend une borne de sortie 301. En fonction du ou des signaux de commande de découpage qu'il reçoit du circuit 20, dans cet exemple le signal cmd qu'il reçoit sur sa borne d'entrée 302, le circuit 30 est configuré pour coupler la borne 102 sélectivement, à la borne 3, à la borne 4, ou éventuellement à aucune de ces bornes 3 et 4. Le couplage sélectif de la borne 301 à la borne 3, à la borne 4, ou à aucune de ces bornes 3 et 4 est mis en oeuvre au moyen d'un ou plusieurs interrupteurs de découpage du circuit 30, commandés par le ou les signaux de commande de découpage.

Dans l'exemple représenté, le circuit 30 comprend deux interrupteurs de découpage 303 et 304 connectés en série entre les bornes 3 et 4 et commandés par le signal cmd. Le noeud de connexion entre les interrupteurs 303 et 304 correspond ici à la borne de sortie 301. Dans cet exemple, l'interrupteur 303 est un transistor MOS, par exemple à canal P, dont la source et le drain sont respectivement connectés aux bornes 301 et 3, et l'interrupteur 304 est un transistor MOS, par exemple à canal N, dont le drain et la source sont respectivement connectés aux bornes 301 et 4, les grilles des transistors 303 et 304 étant couplées, de préférence connectées, à la borne 302.

Le convertisseur 1 comprend de plus un élément inductif 40, par exemple une inductance, couplant la borne 301 du circuit 30 à la borne 5 du convertisseur 1, l'élément inductif 40 étant de préférence connecté aux bornes respectives 301 et 5. En variante, l'élément inductif 40 peut être externe au convertisseur 1. En outre, dans cet exemple, un élément capacitif 50, par exemple un condensateur, couple les bornes 5 et 6, l'élément capacitif 40 étant de préférence connecté aux bornes respectives 5 et 6. L'élément capacitif peut faire partie du convertisseur 1 ou être externe au convertisseur.

En fonctionnement, le signal clk et les tensions Vref et Vin sont fournies au convertisseur 1, et une charge 60 à laquelle le convertisseur 1 fournit la tension Vout est connectée entre les bornes 5 et 6. En fonction du signal clk et des tensions Vref, Vin et Vout, et plus particulièrement en fonction des tensions VR et Verr, le circuit 20 génère le signal cmd de manière à maintenir aux bornes de l'ensemble de la charge 60 et de l'élément capacitif 50, une tension Vout dont la valeur dépend de la tension de consigne Vref, de préférence une tension Vout de valeur sensiblement égale, de préférence égale, à celle de la tension Vref. Plus particulièrement, dans l'exemple décrit, quand les interrupteurs 303 et 304 sont respectivement fermé et ouvert, par exemple quand le signal cmd est à un état logique bas par exemple égal à la masse, et que la tension Vout est inférieure à la tension Vin, de l'énergie est accumulée dans l'élément inductif 40 et le courant IL dans l'élément inductif augmente. A l'inverse, quand les interrupteurs 303 et 304 sont respectivement ouvert et fermé, par exemple quand le signal cmd est à un état logique haut par exemple égal à Vin, de l'énergie est restituée par l'élément inductif 40 à l'ensemble de la charge 60 et l'élément capacitif 50 et le courant IL dans l'élément inductif diminue.

De préférence, quand la tension Vout est égale à la tension Vref, le convertisseur 1, et plus particulièrement l'amplificateur 10, sont configurés de sorte que la tension Verr soit égale à la tension Vref.

Lorsque le courant appelé par la charge 60 augmente, cela entraîne généralement une diminution correspondante de la tension Vout par rapport à la tension de consigne Vref. Il en résulte une augmentation de la tension Verr, et donc une augmentation, pour chaque période du signal cmd, de la durée de son état logique bas, ce qui tend à ramener la tension Vout à la tension Vref.

Lorsqu'une diminution de la tension Vout par rapport à la tension Vref entraîne une saturation de l'amplificateur 10, c'est-à-dire que la tension Verr qu'il fournit atteint une valeur maximale, à savoir la valeur de la tension Vin d'alimentation de l'amplificateur, le circuit 12 commande la boucle de contre réaction 11 de manière à réduire, voire annuler, l'impédance de cette dernière. Il en résulte que la tension Verr tend vers la tension présente sur l'entrée 103 de l'amplificateur, notamment du fait que la capacité 50 entre les bornes 5 et 6 est supérieure, par exemple au moins 5 fois, de préférence au moins 10 fois, à une capacité présente entre les bornes 101 et 4, c'est-à-dire la capacité du noeud 101. Comme la tension Vout est inférieure à la tension Vin, la tension entre les bornes 103 et 4 est inférieure à la tension Vin de saturation de l'amplificateur 10 et la boucle de contre réaction 11 tend à imposer une valeur de tension Verr inférieure à celle de la tension de saturation Vin de l'amplificateur 10. Cela permet de réduire le temps nécessaire pour que l'amplificateur 10 sorte de l'état saturé par rapport au cas d'un convertisseur 1 qui serait dépourvu de la boucle de contre réaction commandable 11 et du circuit 12.

En effet, en l'absence de la boucle de contre réaction commandable 11 et du circuit 12, malgré le fait que, après une diminution de la tension Vout ayant entraîné une saturation de l'amplificateur 10, la tension Vout ait augmenté jusqu'à une valeur telle que la tension Verr devrait être inférieure à la tension de saturation de l'amplificateur 10, l'amplificateur pourrait rester saturé pour encore quelques instants, ce qui pourrait conduire à des oscillations de la tension Vout et/ou à des pics importants de courant IL.

Pour éviter un tel phénomène, on aurait pu penser alimenter l'amplificateur 10 avec une tension Vin suffisamment élevée pour que l'amplificateur 10 ne sature jamais. Toutefois, cela conduirait à une augmentation de la consommation du convertisseur, ce qui n'est pas souhaitable. En outre, cela conduirait à limiter la tension d'alimentation minimale de fonctionnement du convertisseur 1, ce qui peut être particulièrement gênant quand la tension Vin est fournie par une pile ou une batterie.

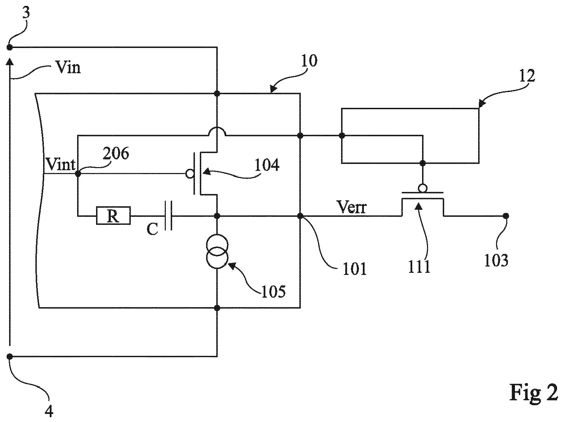

La figure 2 représente, de manière plus détaillée, une partie du convertisseur 1 selon un mode de réalisation. Plus particulièrement, la figure 2 représente le circuit 12, le composant commandable 111, les bornes 3 et 4, et une partie seulement de l'amplificateur 10, à savoir sa borne d'entrée 103 et son étage de sortie fournissant la tension Verr.

Dans ce mode de réalisation, l'étage de sortie, ou étage de gain, de l'amplificateur 10 comprend un transistor MOS 104, dans cet exemple à canal P, et une source de courant 105 polarisant le transistor 104. Le transistor 104 et la source de courant 105 sont connectés en série entre les bornes 3 et 4, le transistor 104 étant ici connecté à la borne 3. La borne de sortie 101 de l'amplificateur 10 correspond au noeud de connexion entre le transistor 104 et la source de courant 105, c'est-à-dire ici à la source du transistor 104. La borne de commande (grille) 106 du transistor 104 reçoit un signal interne Vint de l'amplificateur 10, représentatif de la tension différentielle de l'amplificateur 10, c'est-à-dire de la différence de tension entre les entrées 102 et 103 de l'amplificateur 10. A titre d'exemple, le signal Vint est un signal de sortie d'une paire différentielle. Dans l'exemple représenté, une compensation Miller est prévue dans l'étage de sortie de l'amplificateur 10, une résistance R et une capacité C étant connectées en série entre la grille 106 et la source 101 du transistor 104.

Dans ce mode de réalisation, le circuit 12 est une connexion directe entre la borne de commande (grille) 106 du transistor 104 et la borne de commande du composant 111, c'est-à-dire la grille du transistor 111 dans cet exemple. Dans ce mode de réalisation, le transistor 111 est commandé de manière discrète, en tout ou rien. Autrement dit, le composant 111 correspond à un interrupteur.

L'état saturé ou non de l'amplificateur 10 dépend du signal Vint commandant le transistor 104. Ainsi, le signal Vint permet de détecter une saturation de l'amplificateur 10. Plus particulièrement, dans l'exemple représenté, lors d'une saturation de l'amplificateur 10, la tension Vint entre la grille du transistor 104 et la borne 4 est nulle ou presque. Ainsi, quand l'amplificateur sature, le signal Vint appliqué à la borne de commande de l'interrupteur 111 entraîne la fermeture ce dernier, ou, autrement dit, la tension Vint entre la borne de commande du transistor 111 et la borne 4 est telle que le transistor 111 se ferme.

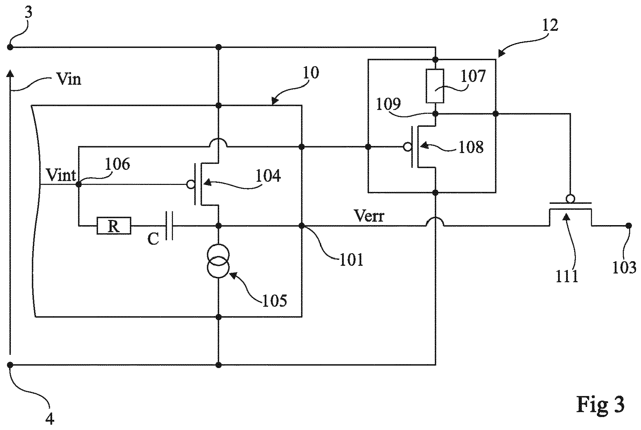

La figure 3 représente, de manière plus détaillée, une partie du convertisseur 1 selon un autre mode de réalisation. Le mode de réalisation de la figure 3 diffère de celui de la figure 2 uniquement par son circuit 12 et par le fait que composant 111 correspond à une résistance variable commandable.

Dans ce mode de réalisation, le circuit 12 est connecté aux bornes 3 et 4 pour être alimenté par la tension Vin. Le circuit 12 comprend une résistance 107 et un transistor MOS 108, dans cet exemple à canal P, connectés en série entre les bornes 3 et 4. Dans cet exemple, une borne de conduction, ici la source, du transistor 108 est connectée à la borne 4, une borne de la résistance 107 est connectée à la borne 3, et le noeud de connexion 109 entre le transistor 108 et la résistance 107 constitue la sortie du circuit 12, le noeud 109 étant connecté à la borne de commande de la résistance variable commandable 111, c'est-à-dire à la borne de commande (grille) du transistor 111 dans cet exemple. En outre, la borne de commande du transistor 108 est connecté à la borne de commande du transistor 104 de l'amplificateur 10 de manière à recevoir le signal interne Vint.

Le fonctionnement est similaire à ce qui a été décrit en relation avec la figure 2, à la différence que, au lieu de commander le composant 111 de manière discrète (interrupteur 111 ouvert ou fermé), le composant 111, dans cet exemple le transistor 111, est ici commandé de manière linéaire, la valeur de la résistance variable 111 diminuant lorsque l'amplificateur 10 s'approche de son état saturé, jusqu'à une valeur minimale quand l'amplificateur sature. Il en résulte une diminution moins brusque de l'impédance de la boucle de contre réaction 11 que dans le mode de réalisation décrit en relation avec la figure 2, d'où il résulte une réponse moins brusque du convertisseur 1 suite à une saturation de l'amplificateur 10.

Le circuit 12 et le composant 111 décrits en relation avec les figures 2 et 3, en particulier quand le composant 111 est un transistor, sont particulièrement simples à mettre en oeuvre, sont peu encombrants et consomment peu.

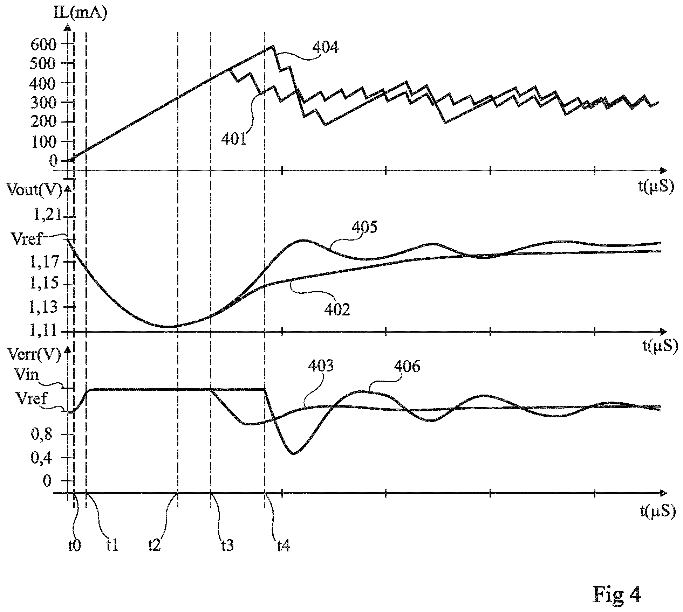

La figure 4 représente des résultats de simulations.

La figure 4 comprend des chronogrammes 401, 402 et 403 obtenus pour un convertisseur 1 selon le mode de réalisation de la figure 3, et des chronogrammes 404, 405 et 406 obtenus pour un convertisseur différant du convertisseur des chronogrammes 401, 402 et 403 par le fait qu'il ne comprend pas le composant 111 et le circuit 12. Les chronogrammes 401, 402, 403, 404, 405 et 406 partagent la même échelle temporelle t, en abscisse et en microsecondes (µs), et illustrent le fonctionnement de ces convertisseurs lors d'un appel de courant par la charge 60 entraînant une saturation de l'amplificateur 10. Dans l'exemple de la figure 4, l'écart entre deux graduations successives des abscisses correspond à 2 µs. Dans cet exemple, la tension Vin est égale à 1,6 V et la tension Vref est égale à 1,2 V.

Plus particulièrement les chronogrammes 401 et 404 illustrent l'évolution du courant IL, en milliampère (mA), dans l'élément inductif 40 (figure 1), les chronogrammes 402 et 405 illustrant l'évolution de la tension Vout, en volts (V), et les chronogrammes 403 et 406 illustrant l'évolution de la tension Verr, en volts (V).

A un instant t0, la tension Vout diminue suite à l'appel de courant, d'où il résulte une augmentation de la tension Verr jusqu'à sa valeur de saturation, 1,6 V dans cet exemple, qu'elle atteint à un instant suivant t1. Tant que la tension Verr reste égale à sa valeur maximale, le circuit 20 (figure 1) commande le circuit 30 (figure 1) de sorte que la borne 102 de l'élément inductif 40 est couplée à la borne 3 et le courant IL augmente.

A un instant t2 suivant l'instant t1, dans cet exemple égal à t0 plus 50 µs, la tension Vout atteint une valeur minimale, l'amplificateur 10 étant toujours saturé et la tension Verr égale à 1,6 V.

A un instant t3 suivant l'instant t2, alors que la tension Vout augmente, dans le convertisseur correspondant aux chronogrammes 401, 402 et 403, du fait que l'impédance de la boucle de contre réaction 11 est réduite, voire nulle, depuis la saturation de l'amplificateur 10 (instant t1), la tension Verr commence à diminuer, alors que, dans le convertisseur correspondant aux chronogrammes 404, 405 et 406, la tension Verr ne commence à diminuer qu'à partir d'un instant t4 postérieur à l'instant t3.

Ainsi, à partir de l'instant t3, les circuits 20 et 30 du convertisseur des chronogrammes 401, 402 et 403 fonctionnent de telle sorte que des phases d'augmentation du courant IL alternent avec des phases de diminution du courant IL, alors que dans le convertisseur des chronogrammes 404, 405 et 406, cela ne se produit qu'à partir de l'instant t4.

On constate alors que la tension Vout du convertisseur des chronogrammes 401, 402 et 403 augmente progressivement jusqu'à la valeur de 1,2 V, sans oscillation, contrairement à ce qui se passe dans le convertisseur des chronogrammes 404, 405 et 406. Du fait que la tension Verr dépend de la tension Vout, la tension Verr ne présente que peu ou pas d'oscillation dans le convertisseur des chronogrammes 401, 402 et 403, contrairement à la tension Verr du convertisseur des chronogrammes 404, 405 et 406. En outre, la tension Verr du convertisseur des chronogrammes 401, 402 et 403 retrouve plus rapidement une valeur stable égale à la tension Vref que celle du convertisseur des chronogrammes 404, 405 et 406.

On constate également que, par rapport au courant IL du convertisseur des chronogrammes 404, 405 et 406, le courant IL du convertisseur des chronogrammes 401, 402 et 403 présente plutôt une alternance régulière de phases d'augmentation et de diminution de sa valeur, et, en outre, présente un courant IL dont la valeur maximale est plus faible.

On a décrit ci-dessus divers modes de réalisation d'un convertisseur à découpage. Ces modes de réalisation sont par exemple adaptés à une utilisation dans un microcontrôleur, par exemple dans une unité de contrôle de l'alimentation (PMU - Power Management Unit) des divers éléments composant le microcontrôleur (mémoire volatile telle qu'une mémoire RAM, mémoire non volatile telle qu'une mémoire flash, bus de données, d'adresses et/ou de contrôle, unité de traitement, interfaces d'entrée/sortie etc...). Dans ce cas, le convertisseur fait partie du microcontrôleur.

Par ailleurs, bien que l'on ait décrit ci-dessus à titre d'exemple le cas d'un convertisseur de tension de type abaisseur (buck), l'homme du métier est en mesure d'adapter, à partir des indications structurelles et/ou fonctionnelles de la présente description, les modes de réalisation décrits à tout convertisseur d'énergie utilisant un amplificateur d'erreur pour mettre en oeuvre des commutations commandées en modulation de largeur d'impulsion, par exemple un convertisseur élévateur (boost), un convertisseur abaisseur/élévateur (buck/boost) pouvant être inverseur (tension Vin positive et tension Vout négative) ou non. Ces autres convertisseurs peuvent en outre être à une ou plusieurs sorties, par exemple un convertisseur abaisseur à plusieurs sorties, un convertisseur abaisseur/élévateur à une sortie positive et une sortie négative, etc...

En outre, bien que l'on ait plus particulièrement décrit une saturation de l'amplificateur 10 à la valeur haute, en valeur absolue, de sa tension d'alimentation Vin, l'homme du métier est en mesure d'adapter les modes de réalisation décrits au cas d'une saturation de l'amplificateur à sa valeur basse, en valeur absolue. Dans un tel cas, le transistor 104 de l'étage de sortie de l'amplificateur 10 (figures 2 et 3) peut par exemple être un transistor à canal N, la source de courant 105 étant alors connectée entre le transistor 104 et la borne 3. Le composant commandable 111 peut alors être mis en oeuvre avec un transistor à canal N, de même que le transistor 108 dans le mode de réalisation de la figure 3.

Plus généralement, bien que l'on ait décrit des modes de réalisation dans lesquels les transistors sont des transistors MOS, l'homme du métier est en mesure d'adapter ces modes de réalisation au cas où au moins certains des transistors utilisés sont des transistors bipolaires.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les modes de réalisation décrits ci-dessus ne se limitent pas aux circuits 20 et 30 représentés en figure 1. Par exemple, le circuit de commande 20 peut être comprendre une machine d'états et/ou fournir plusieurs signaux de commande de découpage (un par interrupteur de découpage du circuit 30). Par exemple, le circuit de commande peut être adapté pour mettre en oeuvre les procédés de commande décrits dans la demande française n°1855400 de la demanderesse.

Plus généralement, on peut prévoir un ensemble d'un amplificateur opérationnel 10, d'un composant commandable 111 (interrupteur ou résistance variable) reliant l'entrée, de préférence inverseuse, à la sortie de l'amplificateur, et d'un circuit de commande 12 du composant commandable, dans d'autres circuits qu'un convertisseur de tension. Par exemple, un tel ensemble peut être prévu dans un circuit où l'amplificateur est un amplificateur d'erreur entre une tension de consigne et une tension de sortie du circuit, le signal de sortie de l'amplificateur déterminant un signal de commande interne au circuit.

Enfin, la mise en oeuvre pratique des modes de réalisation et variantes décrits est à la portée de l'homme du métier à partir des indications fonctionnelles données ci-dessus. En particulier, pour ce qui est du composant 111 et/ou du circuit 12, l'homme du métier est en mesure de prévoir d'autres mises en oeuvre.

## Revendications

1. Dispositif comprenant :
un amplificateur opérationnel (10) ; et
une boucle de contre réaction (11) connectée entre une première entrée (103) de l'amplificateur et une sortie (101) de l'amplificateur, la boucle de contre réaction étant commandable en fonction de la saturation de l'amplificateur et comprenant un interrupteur (111) connecté entre la première entrée (103) et la sortie (101) de l'amplificateur (10), ou une résistance variable commandable (111) connectée entre la première entrée (103) et la sortie (101) de l'amplificateur (10).

2. Dispositif selon la revendication 1, comprenant en outre un circuit (12) de détection d'une saturation de l'amplificateur, configuré pour commander la boucle de contre réaction (11)

3. Dispositif selon la revendication 2, dans lequel le circuit est configuré pour réduire ou annuler l'impédance de la boucle de contre réaction (11) lorsque l'amplificateur (10) sature.

4. Dispositif selon la revendication 2 ou 3, dans lequel le circuit (12) est configuré pour détecter une saturation de l'amplificateur (10) et pour commander la boucle de contre réaction (11) à partir d'un signal interne (Vint) de l'amplificateur.

5. Dispositif selon la revendication 4, dans lequel l'amplificateur (10) comprend un premier transistor (104) dont une borne de conduction constitue la sortie (101) de l'amplificateur, ledit signal interne (Vint) étant reçu par une borne de commande (106) du premier transistor (104).

6. Dispositif selon l'une quelconque des revendications 2 à 5, dans lequel le circuit (12) est configuré pour commander une fermeture de l'interrupteur (111) lorsqu'une saturation est détectée ou pour commander une diminution de la valeur de la résistance variable (111) quand une saturation est détectée.

7. Dispositif selon les revendications 5 et 6, dans lequel le circuit (12) est une connexion directe entre la borne de commande (106) du premier transistor (104) et une borne de commande de l'interrupteur (111).

8. Dispositif selon les revendications 5 et 6, dans lequel le circuit (12) comprend une première résistance (107) et un deuxième transistor (108) connectés en série entre des bornes d'alimentation (3, 4) de l'amplificateur (10), une borne de commande (106) du deuxième transistor (108) étant connectée à la borne de commande (106) du premier transistor (104), et un noeud de connexion (109) entre la première résistance et le deuxième transistor étant connecté à une borne de commande de la résistance variable (111).

9. Dispositif selon l'une quelconque des revendications 1 à 8, dans lequel l'interrupteur (111) ou la résistance variable (111) correspondent à un troisième transistor (111) dont une première borne de conduction est connectée à la première entrée (103) de l'amplificateur (10), et dont une deuxième borne de conduction est connectée à la sortie (101) de l'amplificateur (10).

10. Dispositif selon l'une quelconque des revendications 1 à 9, dans lequel la saturation est une saturation à potentiel d'alimentation haut, en valeur absolue, de l'amplificateur (10).

11. Dispositif selon l'une quelconque des revendications 1 à 10, dans lequel la première entrée (103) est une entrée inverseuse (-) de l'amplificateur (10).

12. Dispositif selon l'une quelconque des revendications 1 à 11, comprenant en outre :
un élément inductif (40) dont une première borne est couplée, de préférence connectée, à une borne de sortie (5) du dispositif ;
un circuit de commutation (30) couplé à une deuxième borne de l'élément inductif (40) ; et
un circuit de commande (20), de préférence en modulation de largeur d'impulsion, configuré pour commander le circuit de commutation (30) au moins en partie sur la base d'un signal (Verr) de sortie de l'amplificateur (10).

13. Dispositif selon l'une quelconque des revendications 1 à 12, le dispositif étant un convertisseur de tension à découpage (1), de préférence un convertisseur abaisseur, abaisseur-élévateur ou inverseur.

14. Microcontrôleur comprenant un convertisseur de tension à découpage selon la revendication 13.

15. Procédé de commande d'un dispositif comprenant un amplificateur opérationnel (10) et une boucle de contre réaction commandable connectée entre une sortie (101) de l'amplificateur et une première entrée (103), de préférence inverseuse (-), de l'amplificateur, le procédé comprenant une étape consistant à réduire ou annuler l'impédance de la boucle de contre réaction (11) lorsqu'une saturation de l'amplificateur est détectée.
